(19) **Europäisches Patentamt European Patent Office Office européen des brevets**

(11) **EP 4 651 684 A1**

(12) **EUROPEAN PATENT APPLICATION**

(43) Date of publication:
**19.11.2025 Bulletin 2025/47**

(21) Application number: **25174389.4**

(22) Date of filing: **06.05.2025**

(51) International Patent Classification (IPC):
**H10H 29/855** $^{(2025.01)}$

(52) Cooperative Patent Classification (CPC):
**H10H 29/855**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **17.05.2024 CN 202410618201**

(71) Applicant: **InnoLux Corporation Jhu-Nan, Miao-Li County 350 (TW)**

(72) Inventors:
• **LI, WEN-TSE**
  **350 Jhu-Nan (TW)**
• **LIAO, SHIH-FU**
  **350 Jhu-Nan (TW)**
• **YAO, I-AN**
  **350 Jhu-Nan (TW)**

(74) Representative: **Dompatent**
  **Deichmannhaus am Dom**
  **Bahnhofsvorplatz 1**
  **50667 Köln (DE)**

(54) **DISPLAY DEVICE**

(57) A display device includes a first substrate, a first light-emitting unit, a first lens unit, a first prism unit, a first intermediate layer, and a second intermediate layer. The first light-emitting unit is disposed on the first substrate. The first lens unit is relatively disposed above the first light-emitting unit. The first prism unit is relatively disposed above the first lens unit. The first intermediate layer is disposed between the first lens unit and the first prism unit, and the second intermediate layer is disposed between the first light-emitting unit and the first lens unit.

FIG. 1A

**Description**

**BACKGROUND**

**Technology Field**

The present invention relates to a display device and, in particular, to a display device having an off-axis brightness center.

**Description of Related Art**

With the development of digital technology, display devices have been widely used in various applications of daily life, such as modern information products including TVs, computers, mobile phones, in-vehicle information system, and etc. In the meanwhile, the display devices are continuously developed and designed towards light, thin, compact, and fashionable. Among existing display devices, the LED display device, especially micro LED display device, has the advantages of low power consumption, high contrast, wide color gamut, high brightness, small size, light weight, thin thickness, and energy saving, so that it has become one of the mainstream display devices.

Considering the usage habits of most users, the brightness center of a conventional display device is usually designed right in front of the display surface. However, in some applications, such as in-vehicle information systems, the user or viewer may not be directly in front of the display device and therefore cannot view the image at the brightness center of the conventional display device.

**SUMMARY**

This invention provides a display device that can focus the brightness center in an off-axis direction.

A display device of this invention includes a first substrate, a first light-emitting unit, a first lens unit, a first prism unit, a first intermediate layer, and a second intermediate layer. The first light-emitting unit is disposed on the first substrate. The first lens unit is disposed above the first light-emitting unit. The first prism unit is disposed above the first lens unit. The first intermediate layer is disposed between the first lens unit and the first prism unit. The second intermediate layer is disposed between the first light-emitting unit and the first lens unit.

**BRIEF DESCRIPTION OF THE DRAWINGS**

The invention will become more fully understood from the detailed description and accompanying drawings, which are given for illustration only, and thus are not limitative of the present invention, and wherein:

FIG. 1A is a sectional view showing a part of a display device according to a first embodiment of this invention;

FIG. 1B is a simplified schematic diagram showing that a light beam emitted from the first light-emitting unit passes through the first lens unit and then directly enters the air;

FIG. 1C is a simplified schematic diagram showing that a light beam emitted from the first light-emitting unit passes through the first lens unit and then directly enters the first intermediate layer;

FIG. 1D is a simplified schematic diagram showing that a light beam sequentially passes through the first intermediate layer, the first prism unit and the second substrate of the display device of FIG. 1A;

FIG. 2A is a sectional view showing a part of a display device according to a second embodiment of this invention;

FIG. 2B is a simplified schematic diagram showing that a light beam sequentially passes through the first intermediate layer, the first prism unit and the second substrate of the display device of FIG. 2A;

FIG. 3A is a sectional view showing a part of a display device according to a third embodiment of this invention;

FIG. 3B is a simplified schematic diagram showing that a light beam sequentially passes through the first intermediate layer, the first prism unit and the second substrate of the display device of FIG. 3A;

FIG. 4 is a sectional view showing a part of a display device according to a fourth embodiment of this invention;

FIGS. 5 and 6 are sectional views showing a part of a display device according to different aspects of a fifth embodiment of this invention; and

FIG. 7 is a top view of a display device according to an embodiment of this invention.

## DETAILED DESCRIPTION OF THE INVENTION

The present invention will be apparent from the following detailed description, which proceeds with reference to the accompanying drawings, wherein the same references relate to the same elements.

It should be understood that the following description provides different embodiments for implementing different aspects of some embodiments of the present invention. The specific components and arrangements described below are used to briefly and clearly describe some embodiments of the present invention. These embodiments are for illustration and are not intended to limit the scope of the present invention. In addition, reference numbers or labels may be repeatedly used in different embodiments. These repetitions are for the purpose of simply and clearly describing some embodiments of the present invention, and do not represent any correlation between the different embodiments and/or structures discussed. Furthermore, when it is mentioned that a certain layer is on or above another layer, the certain layer may directly contact another layer, or one or more other layers or films may be provided between the two layers, so that the certain layer may not directly contact another layer.

Relative terms, such as "lower" and "higher", or "bottom" and "top", may be used in following embodiments to describe the relative relationship of one component to another component in the drawings. It will be understood that if the device shown in the drawings is turned upside down, components described as being at the "lower" side would then be at the "higher" side.

The terms "about", "approximate" and "approximately" usually mean the variation within 20%, preferably within 10%, and more preferably within 5%, 3%, 2%, 1% or 0.5% of a given value or range. The given quantities here are approximate quantities, that is, in the absence of specific description of "about", "approximate", or "approximately", the meaning of "about", "approximate", and "approximately" can still be implied.

It will be understood that, although the terms "first", "second", "third" and the likes may be used herein to describe various elements, components, regions, layers, and/or portions, these elements, components, regions, layers, and/or portions should not be limited by these terms, and these terms are used to distinguish between different elements, components, regions, layers, and/or portions. Thus, a first element, component, region, layer, and/or portion discussed below could be termed a second element, component, region, layer, and/or portion without departing from the teachings of some embodiments of the present invention.

Unless otherwise defined, all terms (including technical and scientific terms) used herein have the same meaning as commonly understood by one of ordinary skill in the related art. It is understood that these terms, such as those defined in commonly used dictionaries, should be interpreted to have a meaning consistent with the relevant technology and the background or content of the present invention, and should not be interpreted in an idealized or overly formal way, unless otherwise defined in the embodiments of this invention.

Some embodiments of the present invention can be understood together with the drawings, and the drawings of the embodiments of the present invention are also regarded as part of the description of the embodiments of the present invention. It should be understood that the drawings of the embodiments of the present invention are not drawn to the actual scale of devices and components. The shapes and thicknesses of embodiments may be exaggerated in the drawings to clearly illustrate features of embodiments of the present invention. In addition, the structures and devices in the drawings are illustrated in a schematic manner in order to clearly demonstrate the features of the embodiments of the present invention.

In some embodiments of the present invention, relative terms such as "lower", "upper", "parallel", "vertical", "below", "above", "top", "bottom", etc., shall be understood as the orientations shown in this paragraph and related drawings. This relative terms are for convenience of explanation and does not mean that the device described needs to be manufactured or operated in a specific orientation. Terms related to joining and connecting, such as "connect", "joint", etc., unless otherwise defined, can mean that two structures are in direct contact, or they can also mean that the two structures are not in direct contact with one or more additional structures located therebetween. The terms related to joining and connecting two structures can also include the situation that both structures are movable, or both structures are fixed.

To be noted, the term "substrate" in this invention may include components formed on a transparent substrate and various film layers covering the substrate, on which any required active components (e.g. transistors) may be formed. In order to simplify the drawings, a flat substrate is shown.

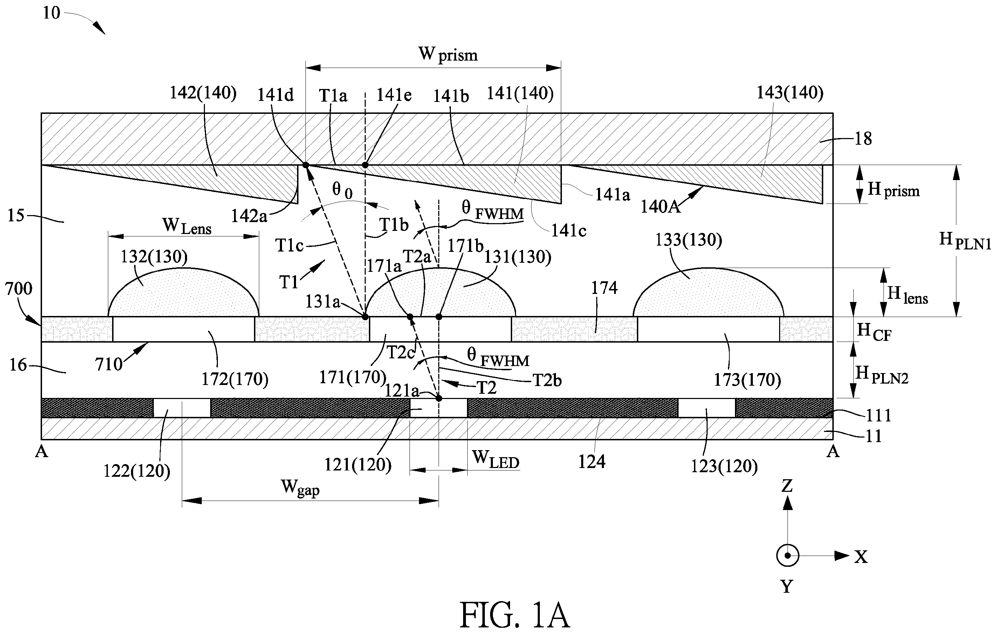

FIG. 1A is a sectional view showing a part of an electronic device 10 according to a first embodiment of this invention. In this embodiment, the electronic device 10 is, for example, a display device 10. For convenience of explanation, the display device 10 is taken as an example for description below. As shown in FIG. 1A, the display device 10 may include a first substrate 11, a plurality of light-emitting units 120, a plurality of lens units 130, a plurality of prism units 140, a first intermediate layer 15, and a second intermediate layer 16. The plurality of light-emitting units 120 are disposed on the first substrate 11, the plurality of lens units 130 are respectively disposed above the plurality of light-emitting units 120, and the plurality of prism units 140 are respectively disposed above the plurality of lens units 130. The first intermediate layer 15 is disposed between the plurality of lens units 130 and the plurality of prism units 140. The second intermediate layer 16 is disposed between the plurality of light-emitting units 120 and the plurality of lens units 130.

In this embodiment, the material of the first intermediate layer 15 may include optically clear adhesive (OCA), optically clear resin (OCR), or any of other suitable transparent adhesive materials (e.g. photoresist materials), and this invention is not limited thereto. In this embodiment, the material of the second intermediate layer 16 may include optically clear adhesive (OCA), optically clear resin (OCR), or any of other suitable transparent adhesive materials (e.g. photoresist materials), and this invention is not limited thereto. In one embodiment, the first intermediate layer 15 and/or the second intermediate layer 16 may be composed of air without having any film material, and this invention is not limited thereto. In one embodiment, the first intermediate layer 15 and/or the second intermediate layer 16 may be a planarization layer, and this invention is not limited thereto. To be noted, the first intermediate layer 15 and the second intermediate layer 16 can be made of the same material or different materials, and this invention is not limited thereto.

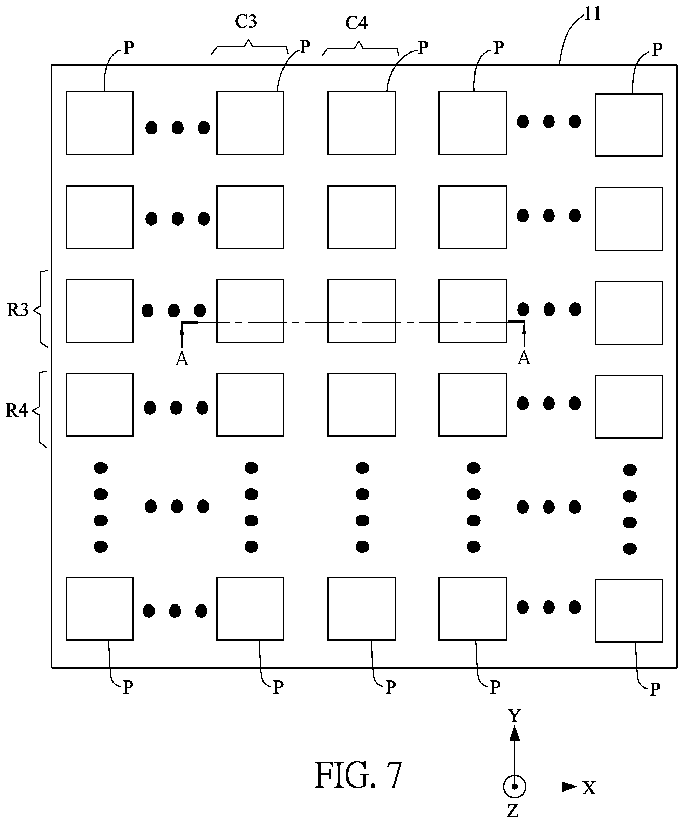

Referring to FIG. 7, the first substrate 11 includes a plurality of pixel areas P, which can be arranged in a matrix. FIG. 1A is a schematic sectional view along the line A-A in FIG. 7, and FIG. 1A simply shows a part of the first substrate 11 including three pixel areas P. As shown in FIG. 1A, one of the light-emitting units 120 corresponds to one of the pixel areas P. Regarding one pixel area P, for example, the first light-emitting unit 121 is disposed on the first substrate 11 and is located in the pixel area P1. One of the lens units 130 (e.g. the first lens unit 131) is relatively disposed above the first light-emitting unit 121. One of the prism units 140 (e.g. the first prism unit 141) is relatively disposed above the first lens unit 131. The first intermediate layer 15 is disposed between the first lens unit 131 and the first prism unit 141, and the second intermediate layer 16 is disposed between the first light-emitting unit 121 and the first lens unit 131. In FIG. 1A, "relatively dispose" represents "relatively dispose in the normal direction Z of the first substrate 11". That is, the first lens unit 131 may overlap the first prism unit 141 in the direction Z, and the first prism unit 141 may overlap the first light-emitting unit 121 in the direction Z.

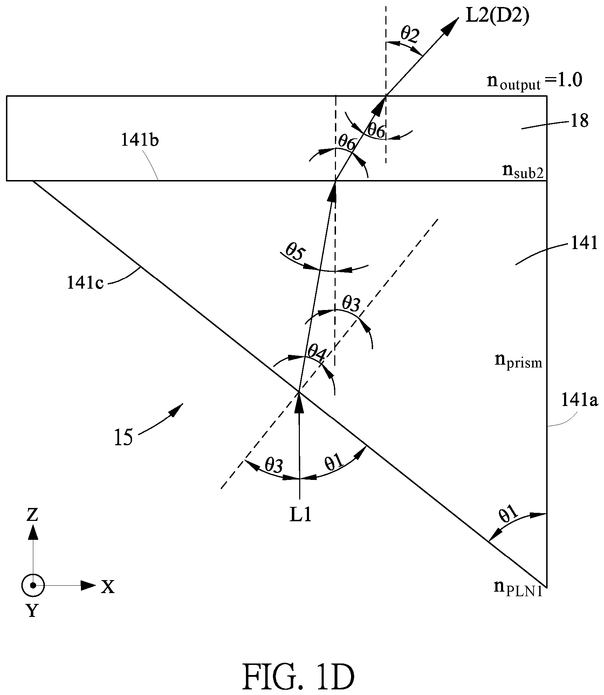

Referring to FIG. 1A, generally, the brightness center of the light-emitting unit 120 is in front of the light-emitting unit 120 in the normal direction Z of the first substrate 11. This invention is configured with a plurality of prism units 140 in an appropriate arrangement to cause off-axis of the output light L2 of the display device 10 with relative to the normal direction Z. As shown in FIG. 1D, the off-axis angle of the output light L2 with relative to the normal direction Z is defined as a second angle $\theta_2$. That is, the included angle is between the direction D2 of the output light L2 and the normal direction Z of the second angle $\theta_2$. The maximum brightness (brightness center) of the outputted light beam (i.e., the output light L2) is in the direction D2. In other words, when measuring the overall brightness of the outputted light beam, the brightness measured in the direction D2 is greater than the brightness measured in the direction Z.

In some embodiments, as shown in FIG. 1A, the second light-emitting unit 122 and the third light-emitting unit 123 are disposed on the first substrate 11. The second lens unit 132 is relatively disposed above the second light-emitting unit 122, and the third lens unit 133 is relatively disposed above the third light-emitting unit 123. The prism unit 142 is relatively disposed above the second lens unit 132, and the third prism unit 143 is relatively disposed above the third lens unit 133. The first intermediate layer 15 is disposed between the lens units (including the first lens unit 131, the second lens unit 132 and the third lens unit 133) and the prism units (including the first prism unit 141, the second prism unit 142 and the third prism unit 143), and the second intermediate layer 16 is disposed between the light-emitting units (including the first light-emitting unit 121, the second light-emitting unit 122 and the third light-emitting unit 123) and the lens units (including the first lens unit 131, the second lens unit 132 and the third lens unit 133). For convenience of explanation, three pixel areas P and three light-emitting units 120 are shown in FIG. 1A, but this invention is not limit thereto. Other light-emitting units 120, other lens units 130, and other prism units 140 can be arranged in a similar manner as described above, and the detailed described thereof will be omitted.

In addition, as shown in FIG. 1A, the display device 10 of this embodiment may further include a plurality of color filter units 170 respectively disposed between the plurality of light-emitting units 120 and the plurality of lens units 130. In the direction Z, one color filter unit 170 can be disposed corresponding to one lens unit 130 and one light-emitting unit 120. Taking one light-emitting unit (e.g. the first light-emitting unit 121) as an example, the first color filter unit 171 can be provided corresponding to the first lens unit 131 and the first light-emitting unit 121. Specifically, the first color filter unit 171 can be disposed overlapping (above) the first lens unit 131 and overlapping (above) the first light-emitting unit 121. The color filter unit 170 can be a red color filter unit, a green color filter unit, a blue color filter unit, or a color filter unit of any other color, and this invention is not limited thereto. In some embodiments, three adjacent color filter units may be different color filter units. For example, as shown in FIG. 1A, the color filter units 172, 171 and 173 may be different color filter units. In this case, the color filter unit 172 is a red color filter unit, the color filter unit 171 is a green color filter unit, and the color filter unit 173 is a blue color filter unit.

In some embodiments, as shown in FIG. 1A, the plurality of color filter units 170 may further include a second color filter unit 172 and a third color filter unit 173. The second color filter unit 172 is disposed between the second light-emitting unit 122 and the second lens unit 132, and the second intermediate layer 16 is further disposed between the second light-emitting unit 122 and the second color filter unit 172. The third color filter unit 173 is disposed between the third light-emitting unit 123 and the third lens unit 133, and the second intermediate layer 16 is further disposed between the third light-emitting unit 123 and the third color filter unit 173. For convenience of explanation, three pixel areas P as well as three color filter units 170 are shown in FIG. 1A, but this is not used to limit the present invention. The third color filter unit 173 and other color filter units can also be arranged correspondingly in a similar manner as described above, so the detailed descriptions thereof will be omitted.

In one embodiment, the light shielding units 174 can be disposed between the color filter units 170. For example, as shown in FIG. 1A, a light-shielding material layer 700a can be formed on the second intermediate layer 16 by, for example, a coating or printing process, and then the light-shielding material layer 700 can be patterned by, for example, a photolithography process to form a plurality of light shielding units 174. In this case, a plurality of openings 710 can be defined between the light shielding units 174. Afterwards, a plurality of color filter units 170 can be respectively disposed in the plurality of openings 710 of the light-shielding material layer 700, so that light shielding units 174 can be disposed between the color filter units 170. For example, one light shielding unit 174 may be disposed between two adjacent color filter units 171 and 172. In some embodiments, the light-shielding material layer 700 and the light shielding unit 174 may include organic materials (e.g. black organic materials), organic photoresist (e.g. black organic photoresist), or the likes.

Referring to FIG. 1A, the first lens unit 131, the second lens unit 132, and the third lens unit 133 are respectively disposed above the first light-emitting unit 121, the second light-emitting unit 122, and the third light-emitting unit 123, and are configured to respectively collect and concentrate the lights emitted by the first light-emitting unit 121, the second light-emitting unit 122 and the third light-emitting unit 123. Therefore, the lights passing through the first lens unit 131, the second lens unit 132 and the third lens unit 133 are mostly concentrated in the direction parallel to the normal direction Z of the upper surface 111 of the first substrate 11. This design can improve the overall brightness and light extraction efficiency of the display device 10. To be noted, the upper surface 111 of the first substrate 11 is parallel to the plane defined by the direction X and the direction Y, and the normal direction Z is perpendicular to the upper surface 111 of the first substrate 11.

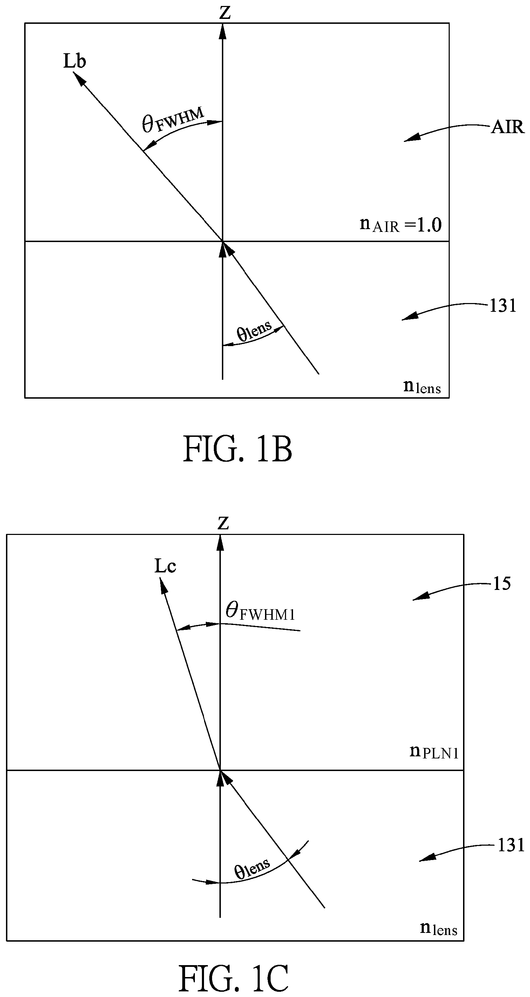

FIG. 1B is a simplified schematic diagram showing that a light beam emitted from the first light-emitting unit 121 passes through the first lens unit 131 and then directly enters the air, and FIG. 1C is a simplified schematic diagram showing that a light beam emitted from the first light-emitting unit 121 passes through the first lens unit 131 and then directly enters the first intermediate layer 15.

As shown in FIG. 1B, taking the first light-emitting unit 121 as an example, assuming that the light emitted from the first light-emitting unit 121 passes through the first lens unit 131 and then directly enters the air medium AIR, the first light-emitting unit 121 may be defined with an angle of FWHM (full width at half maximum) $\theta_{FWHM}$. The light emitted from the first light-emitting unit 121 has the maximum brightness in the direction parallel to the normal direction Z of the first substrate 11. The brightness of the light emitted from the first light-emitting unit 121 will gradually weaken as the off-axis angle with respective to the normal direction Z increases. When the intensity of the light weakens to 50% of the maximum brightness, the off-axis angle of the light is defined as the angle of FWHM $\theta_{FWHM}$. That is, as shown in FIG. 1B, the brightness of the light beam Lb is 50% of the maximum brightness, and the included angle between the direction of the light beam Lb and the normal direction Z of the first substrate 11 can be defined as the angle of FWHM $\theta_{FWHM}$. According to FIG. 1B and Snell's law, the following equation (1) can be obtained:

$$\sin(\theta_{lens}) * n_{lens} = \sin(\theta_{FWHM}) * 1.0 \qquad\qquad \text{equation (1)}$$

Wherein, $\theta_{lens}$ represents the incident angle of the light beam entering the air medium AIR from the first lens unit 131, $n_{lens}$ represents the refractive index of the first lens unit 131, $\theta_{FWHM}$ represents the refraction angle of the light beam entering the air medium AIR from the first lens unit 131, and $n_{air}$ represents the refractive index of the air medium AIR.

In addition, as shown in FIG. 1C, taking the first light-emitting unit 121 as an example, assuming that the light emitted from the first light-emitting unit 121 passes through the first lens unit 131 and then directly enters the first intermediate layer 15, the first light-emitting unit 121 may be defined with an angle of FWHM $\theta_{FWHM1}$. The light emitted from the first light-emitting unit 121 and passing through the first lens unit 131 has the maximum brightness in the direction parallel to the normal direction Z of the first substrate 11. The brightness of the light emitted from the first light-emitting unit 121 will gradually weaken as the off-axis angle with respective to the normal direction Z increases. When the intensity of the light weakens to 50% of the maximum brightness, the off-axis angle of the light is defined as the angle of FWHM $\theta_{FWHM1}$. That is, as shown in FIG. 1C, the brightness of the light beam Lc is 50% of the maximum brightness, and the included angle between the direction of the light beam Lc and the normal direction Z of the first substrate 11 can be defined as the angle of FWHM $\theta_{FWHM1}$. According to FIG. 1C and Snell's law, the following equation (2) can be obtained:

$$\sin(\theta_{lens}) * n_{lens} = \sin(\theta_{FWHM1}) * n_{PLN1} \qquad\qquad \text{equation (2)}$$

Wherein, $\theta_{lens}$ represents the incident angle of the light beam entering the first intermediate layer 15 from the first lens unit 131, $n_{lens}$ represents the refractive index of the first lens unit 131, $\theta_{FWHM1}$ represents the refraction angle of the light beam entering the first intermediate layer 15 from the first lens unit 131, and $n_{PLN1}$ represents the refractive index of the first intermediate layer 15.

The equation (1) and the equation (2) can be combined to obtain the following equation (3):

$$\sin(\theta_{FWHM1}) * n_{PLN1} = \sin(\theta_{FWHM}) * 1.0 \qquad \text{equation (3)}$$

As shown in FIG. 1A, in the sectional view of the display device 10, the first prism unit 141 has a first side 141a, a second side 141b, and a hypotenuse 141c, wherein the first side 141a is parallel to a normal direction Z of the first substrate 11, and the second side 141b connects the first side 141a to form a right angle. The first prism unit 141 is disposed corresponding to the first lens unit 131. That is, the first prism unit 141 is disposed overlapping the first lens unit 131 in the normal direction Z. A first included angle $\theta_0$ is defined by the normal direction Z of the first substrate 11 and a line from an end 131a of the first lens unit 131 to an end 141d of the corresponding first prism unit 141. The end 141d is the intersection point of the hypotenuse 141c and the second side 141b of the first prism unit 141. The end 131a of the first lens unit 131 and the end 141d of the first prism unit 141 are located at the same side (e.g. the left side). Therefore, in order to effectively improve the brightness and light extraction efficiency, the first included angle $\theta_0$ can be designed to be greater than or equal to the angle of FWHM $\theta_{FWHM1}$. That is, at least 50% of the light approximating to the maximum brightness can be received by the first prism unit 141. In other words, by designing the first included angle $\theta_0$ to have a minimum angle, it is possible to design the first prism unit 141 to have a minimum width (the lower limit of the width). The following equation (4) can be derived from the above equation (3). That is, the first included angle $\theta_0$ matches the following equation (4):

$$\theta_0 \geq \theta_{FWHM1} = \arcsin\left[\sin(\theta_{FWHM})/n_{PLN1}\right] \qquad \text{equation (4)}$$

In other embodiments, the angle of FWHM $\theta_{FWHM}$ can be measured at the light output position of the lens unit 130. In practice, the measured angle value of the angle $\theta_{FWHM}$ can be substituted into equation (4) so as to calculate the lower limit of the first included angle $\theta_0$ and to obtain an appropriate first intermediate layer 15 based on the refractive index $n_{PLN1}$ of the first intermediate layer 15.

With considering the positions of two adjacent light-emitting units, the first included angle $\theta_0$ can be designed to have a maximum angle, which can be used to define the upper limit of the width of the first light-emitting unit 141. The maximum range of the first included angle $\theta_0$ can be defined according to the width of the light-emitting unit (e.g. the first light-emitting unit 121) and the width of the lens unit (e.g. the first lens unit 131), which will be discussed hereinafter. That is, the off-axis of the light emitted from the lowermost edge to the uppermost edge of the first intermediate layer 15 will not exceed the center between two adjacent light-emitting units (e.g. the first light-emitting unit 121 and the second light-emitting unit 122). This limitation is necessary because that if the width of the prism unit 140 in one pixel is too wide, the light emitted by one pixel may affect the light emitted by adjacent pixels. Therefore, the triangle T1 can be defined as follows: its vertex angle is equal to the first included angle $\theta_0$, its height is equal to the thickness (or height) of the first intermediate layer 15, and its base is equal to a half of the distance between two adjacent light-emitting units (e.g. the distance between the centers of the first light-emitting unit 121 and the second light-emitting unit 122) minus a half of the width of the first lens unit 131. In other words, as shown in FIG. 1A, the triangle T1 has three vertices, wherein the first vertex corresponds to an end 131a of the first lens unit 131, the second vertex corresponds to an end 141d of the first prism unit 141, and the third vertex corresponds to the intersection point 141e of the second side 141b of the first prism unit 141 and a line extending from the end 131a in the normal direction Z. Therefore, the triangle T1 includes a first side T1a (from the end 141d to the intersection point 141e), a second side T1b (from the intersection point 141e to the end 131a), and a hypotenuse T1c (from the end 131a to the end 141d), wherein the first side T1a is perpendicular to the second side T1b, the first side T1a is the base of the triangle T1, and the second side T1b is the height of the triangle T1. In this case, based on the upper limit of the first included angle $\theta_0$, it is possible to design the width of the first prism unit 141 to have an upper limit. According to the trigonometric function of triangle T1, the following equation (5) can be obtained; that is, the first included angle $\theta_0$ matches the following equation (5):

$$\theta_0 \leq \arctan\left[(W_{gap}/2 - W_{lens}/2)/H_{PLN1}\right] \qquad \text{equation (5)}$$

Wherein, $W_{gap}$ represents the distance between two adjacent light-emitting units (e.g. the first light-emitting unit 121 and the second light-emitting unit 122), which can be defined as the distance between the center of the first light-emitting unit 121 and the center of the adjacent second light-emitting unit 122, $W_{lens}$ represents the width of the first lens unit 131, and $H_{PLN1}$ represents the thickness (or height) of the first intermediate layer 15. For convenience of identification, in FIG. 1A, the width $W_{lens}$ is indicated at the position of the second lens unit 132, and the first lens units 131 may have the same width

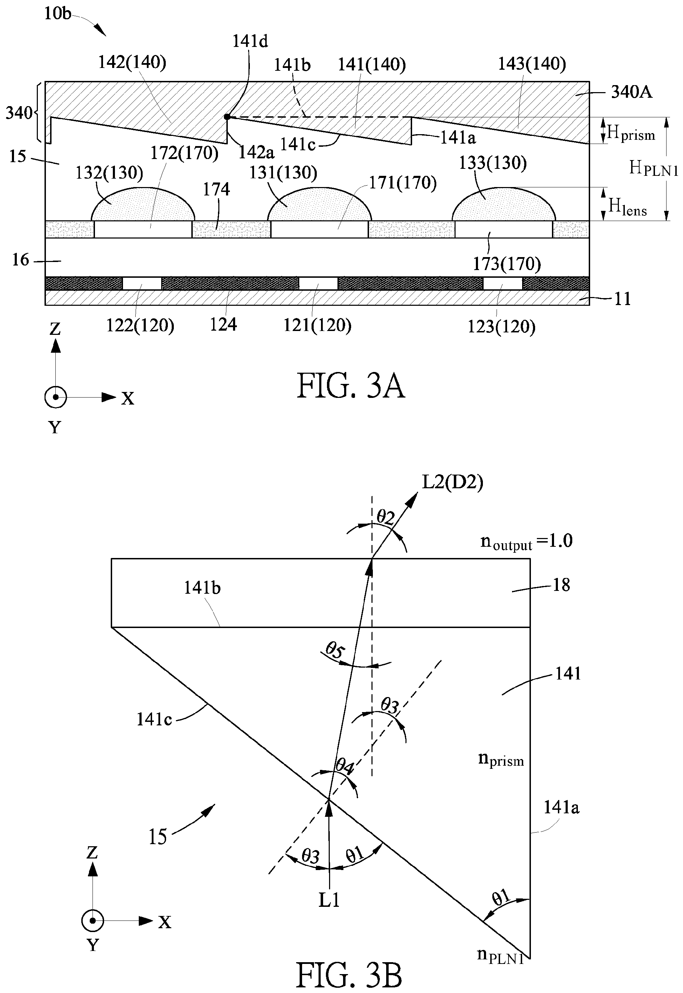

$W_{lens}$. As mentioned above, the lower limit of the first included angle $\theta_0$ can be calculated based on the equation (4), and the upper limit of the first included angle $\theta_0$ can be calculated based on the equation (5). Accordingly, the lens unit 130 and the prism unit 140 can be arranged at appropriate positions to comply with the range of the above-mentioned first included angle $\theta_0$. For example, an appropriate value of the first included angle $\theta_0$ can be selected within the range of the upper limit and the lower limit of the first included angle $\theta_0$. In some embodiments, a distance may be provided between two adjacent prism units 140. For example, as shown in FIG. 1A, a distance (or gap) can be provided between the end 141d of the first prism unit 141 and the first side 142a of the second prism unit 142. In some embodiments, two adjacent prism units 140 may be connected to each other. For example, as shown in FIG. 3A, the end 141d of the first prism unit 141 may connect the first side 142a of the second prism unit 142. To be noted, the above description is an example, and is not to limit this invention.

In addition, the following simulation is performed with assuming that the first intermediate layer 15 is air (i.e., $n_{PLN1}$=1.0). The design and simulation results according to the present invention show that the range of the angle $\theta_{FWHM}$ can be, for example, defined within the width of the light-emitting unit (e.g. the first light-emitting unit 121). Therefore, the triangle T2 can be defined as follows, wherein its vertex angle is equal to the angle $\theta_{FWHM}$, its height is equal to the total thickness (or total height) of the second intermediate layer 16 and the color filter unit (e.g. the first color filter unit 171, the second color filter unit 172 and/or the third color filter unit 173), and its base is equal to a half of the width of the light-emitting unit (e.g. the first light-emitting unit 121). In other words, as shown in FIG. 1A, the triangle T2 has three vertices, wherein the first vertex corresponds to a center point 121a of the first light-emitting unit 121, the second vertex corresponds to the intersection point 171a of the light beam corresponding to the angle $\theta_{FWHM}$ and the top surface of the first color filter unit 171, and the third vertex corresponds to the intersection point 171b of the line extending from the center point 121a in the normal direction Z and the top surface of the first color filter unit 171. Therefore, the triangle T2 includes a first side T2a (from the intersection point 171a to the intersection point 171b), a second side T2b (from the intersection point 171b to the center point 121a), and a hypotenuse T2c (from the center point 121a to the intersection point 171a), wherein the first side T3a is perpendicular to the second side T2b, the first side T2a is the base of the triangle T2, and the second side T2b is the height of the triangle T2. In this case, according to the tangent function of triangle T2, the angle $\theta_{FWHM}$ can be defined as the following equation (6):

$$\theta_{FWHM} = \arctan\left[W_{LED}/2/(H_{CF} + H_{PLN2})\right] \qquad \text{equation (6)}$$

Wherein, $W_{LED}$ represents the width of the first light-emitting unit 121, $H_{CF}$ represents the thickness (or height) of the color filter unit 170 (e.g. the first color filter unit 171, the second color filter unit 172, and/or the third color filter unit 173), and $H_{PLN2}$ represents the thickness (or height) of the second intermediate layer 16. In practice, since the first light-emitting unit 121 can be a commercially available or any pre-manufactured component, its width ($W_{LED}$) can be known in advance, and the angle $\theta_{FWHM}$ thereof can also be known or can be calculated. Therefore, the known parameters can be substituted into the above equation (6) to calculate the applicable thickness or height ($H_{CF}$) of the color filter unit 170 and/or the thickness or height ($H_{PLN2}$) of the second intermediate layer 16, thereby further designing and manufacturing the color filter units 170 and/or the second intermediate layer 16 in the display device 10 of this embodiment based on the calculated thicknesses or heights. In some embodiments, the angle $\theta_{FWHM}$ obtained from the equation (6) can be substituted into the equation (4) so as to calculate the lower limit of the first included angle $\theta_0$, and then the range of the refractive index $n_{PLN1}$ of the first intermediate layer 15 can be obtained. Afterwards, a suitable material for forming the first intermediate layer 15 can be selected based on the obtained range of the refractive index $n_{PLN1}$.

According to the design of the present invention, the first included angle $\theta_0$ can be obtained directly by calculation instead of measurement. As shown in FIG. 1A, in the triangle T1, its base can be defined as the width of the part of the prism unit (e.g. the first prism unit 141) beyond the corresponding lens unit (e.g. the first lens unit 131). That is, the first side T1a is equal to a half of the width of the prism unit (e.g. the first prism unit 141) minus a half of the width of the first lens unit 131 ($W_{prism}/2$ - $W_{lens}/2$), so the aforementioned first included angle $\theta_0$ can also be defined as the following equation (7):

$$\theta_0 = \arctan\left[(W_{prism}/2 - W_{lens}/2)/H_{PLN1}\right] \qquad \text{equation (7)}$$

Wherein, $W_{prism}$ represents the width of the prism unit (e.g. the first prism unit 141), $W_{lens}$ represents the width of the lens unit (e.g. the first lens unit 131), and $H_{PLN1}$ represents the thickness (or height) of the first intermediate layer 15. Accordingly, the range of the first included angle $\theta_0$ can be obtained based on the above equations (4) and (5), and then a specific value of the first included angle $\theta_0$ within the range can be selected and substituted into the above equation (7) so as to calculate the appropriate values of the widths $W_{prism}$ and $W_{lens}$, and the height $H_{PLN1}$. These calculated values of the widths and height (or thickness) can be applied to the process design when producing the display device 10.

As mentioned above, on the premise of obtaining the effective configurations of one or more light-emitting units 120, one or more lens units 130, one or more prism units 140, and the first intermediate layer 15, and effectively improving the brightness and light extraction efficiency, the present invention can utilize the aforementioned equations (4) and (5) to define the range of the first included angle $\theta_0$. To be noted, the above descriptions are examples and are not intended to limit the present invention, and the scope of the present invention is not limited thereto.

Referring to FIG. 1D, the following describes the off-axis design of the output light of the light-emitting unit; that is, the off-axis design of the output light L2 (the second angle $\theta_2$) of the light emitting unit L2 will be described with reference to FIGS. 1A and 1D, wherein FIG. 1D is a simplified schematic diagram showing that a light beam sequentially passes through the first intermediate layer 15, the first prism unit 141 and the second substrate 18 of the display device 10 of FIG. 1A. As shown in FIGS. 1A and 1D, the first light-emitting unit 121 generates an emitted light L1, and the emitted light L1 at least passes through the first lens unit 131, the first intermediate layer 15, and the first prism unit 141. Then, the emitted light L1 is outputted from the display device 10 to form an output light L2 into an environment. In a sectional view of the display device 10, as shown in FIG. 1D, the first prism unit 141 includes a first side 141a, a second side 141b and a hypotenuse 141c. The first side 141a is parallel to the normal direction Z of the first substrate 11, the second side 141b connects the first side 141a to form a right angle, and the first side 141a connects the hypotenuse 141c to form a first angle $\theta_1$. Referring to FIG. 1D, in this embodiment, the hypotenuse 141c is disposed adjacent to the first intermediate layer 15. That is, the hypotenuse 141c is closer to the first intermediate layer 15 than the second side 141b. The included angle of the output light L2 entering the environment and the normal direction Z of the first substrate 11 is defined as a second angle $\theta_2$. According to FIG. 1D and Snell's law, the following equations can be obtained:

$$\theta_3 = 90 - \theta_1 \qquad \text{equation (8)}$$

$$\theta_4 = \arcsin [ \sin(\theta_3) * n_{PLN1}/n_{prism}] \qquad \text{equation (9)}$$

$$\theta_5 = \theta_3 - \theta_4 \qquad \text{equation (10)}$$

$$n_{prism} * \sin(\theta_5) = n_{sub2} * \sin(\theta_6) = n_{output} * \sin(\theta_2) \qquad \text{equation (11)}$$

$$\theta_2 = \arcsin [ \sin(\theta_5) * n_{prism}/n_{output}] \qquad \text{equation (12)}$$

Wherein, equation (12) is derived from Equation (11), $\theta_1$ represents the first angle, $\theta_3$ represents the incident angle of light beam entering the hypotenuse 141c, $\theta_4$ represents the refraction angle of the light beam after passing through the hypotenuse 141c, $\theta_5$ represents the incident angle of the light beam entering the second side 141b, $\theta_6$ represents the refraction angle of the light beam after passing through the second side 141b, $n_{PLN1}$ represents the refractive index of the first intermediate layer 15, $n_{prism}$ represents the refractive index of the first prism unit 141, $n_{sub2}$ represents the refractive index of the second substrate 18, $n_{output}$ represents the refractive index of the environment, and $\theta_2$ represents the second angle.

The angle $\theta_5$ can be obtained by substituting the equations (8) and (9) into the equation (10), and the obtained angle $\theta_5$ is then substituted into the equation (12). Then, the second angle $\theta_2$ can be organized into the following equation (13):

$$\theta_2 = \arcsin [\sin(90 - \theta_1 - \arcsin[\sin(90 - \theta_1)*n_{PLN1}/n_{prism}])*n_{prism}/n_{output}] \quad \text{equation (13)}$$

If the environment is air, $n_{output}$ will be equal to 1.0, and the second angle $\theta_2$ can be organized into the following equation (14):

$$\theta_2 = \arcsin [\sin(90 - \theta_1 - \arcsin[\sin(90 - \theta_1)*n_{PLN1}/n_{prism}])*n_{prism}] \quad \text{equation (14)}$$

With considering the error range of 10 degrees, the above equation (14) can be rewritten as the following equation (15):

$$\theta_2 = \arcsin [\sin(90 - \theta_1 - \arcsin[\sin(90 - \theta_1)*n_{PLN1}/n_{prism}])*n_{prism}] \pm 10 \quad \text{equation (15)}$$

In this embodiment, the thickness of the first intermediate layer 15 can be defined as being greater than or equal to the sum of the thicknesses of the first prism unit 141 and the first lens unit 131 (i.e., $H_{PLN1} \geq H_{prism} + H_{lens}$). Wherein, $H_{PLN1}$

represents the thickness (or height) of the first intermediate layer 15, $H_{prism}$ represents the thickness (or height) of the first prism unit 141, and $H_{lens}$ represents the thickness (or height) of the first lens unit 131.

In brief, as shown in FIG. 1D, on the premise that the output light L2 of the display device 10 can have an expected off-axis angle (i.e., the second angle $\theta_2$), the present invention can use the aforementioned equations (13) to (15) to define the range of the first angle $\theta_1$. In other words, if it is desired to make the output light L2 have an expected off-axis angle (i.e., the second angle $\theta_2$), the angle between the hypotenuse 141c of the first prism unit 141 and the normal direction Z can be designed to be the first angle $\theta_1$, which is to design the inclination of the hypotenuse 141c of the first prism unit 141. The internal structures of the display device 10 can be designed and manufactured according to the aforementioned equations (13) to (15). For example, the first angle $\theta_1$ (i.e., the shape and size of the first prism unit 141), the refractive index $n_{prism}$ of the first prism unit 141 (i.e., the material of the first prism unit 141), the refractive index $n_{PLN1}$ of the first intermediate layer 15 (i.e., the material of the first intermediate layer 15), and the likes can be defined according to the aforementioned equations (13) to (15).

In some embodiments, the display device 10 may be used in the in-vehicle information system. For example, when the display device 10 is installed in a vehicle, if the passenger at a specific position (e.g. at the front passenger seat) is not at the position in front of the display device 10, the passenger may not be able to see the clear image from the display device 10. Therefore, according to the design of the above-mentioned display device 10, the off-axis angle (the second angle $\theta_2$) of the output light L2 can be designed to match the viewing angle of the passenger at the front passenger seat. That is, the brightness center of the output light of the display device is in an off-axis angle (to the second angle $\theta_2$). In this way, the passenger's position (viewing angle) can be located at the brightness center of the display device 10. Therefore, even if the passenger is not located at the position in front of the display device 10, he/she can see a clear image at the off-axis angle (the second angle $\theta_2$) of the light output L2.

Referring to FIG. 1A, the display device 10 of this embodiment may further include a second substrate 18 disposed above the first prism unit 141, the second prism unit 142, and the third prism unit 143. The first prism unit 141, the second prism unit 142, and the third prism unit 143 may be disposed between the first intermediate layer 15 and the second substrate 18. The second substrate 18 can be a transparent substrate, so the light emitted from the first light-emitting unit 121, the second light-emitting unit 122 and/or the third light-emitting unit 123 can at least sequentially pass through the second intermediate layer 16, the corresponding color filter units (e.g. the first color filter unit 171, the second color filter unit 172, and/or the third color filter unit 173), the corresponding lens units (e.g. the first lens unit 131, the second lens unit 132, and/or the third lens unit 133), the first intermediate layer 15, and the corresponding prism units (e.g. the first prism unit 141, the second prism unit 142, and/or the third prism unit 143), and finally outputted from the second substrate 18. To be noted, the second substrate 18 can be any light-transmissive material, which can be, for example but not limited to, the same as the material of any of the first lens unit 131, the second lens unit 132, the third lens unit 133, the first prism unit 141, the second prism unit 142, the third prism unit 143, the first intermediate layer 15 and the second intermediate layer 16, so the detailed description thereof will be omitted.

Referring to FIG. 1A, in this embodiment, the first prism unit 141, the second prism unit 142, and the third prism unit 143 may be manufactured in any suitable manner. In one embodiment, the second intermediate layer 16 and a plurality of color filter units (including the first color filter unit 171, the second color filter unit 172, and the third color filter unit 173), a plurality of lens units (including the first lens unit 131, the second lens unit 132, and the third lens unit 133), and the first intermediate layer 15 can be formed sequentially on the first substrate 11, and then the first intermediate layer 140 is formed with a plurality of recesses 140A, the shape of which correspond to a plurality of prism units (including the first prism unit 141, the second prism unit 142, and the third prism unit 143), by, for example, pressing or stamping. Afterwards, the materials of the first prism unit 141, the second prism unit 142, and the third prism unit 143 are filled into the recesses 140A, thereby forming the expected first prism unit 141, the second prism unit 142, and the third prism unit 143. In other embodiments, the first prism unit 141, the second prism unit 142, and the third prism unit 143 may be formed on the second substrate 18 by, for example, the photolithography process or the pressing process, and then the second substrate 18 formed with the first prism unit 141, the second prism unit 142 and the third prism unit 143 is directly pressed onto the first intermediate layer 15. In this case, the side of the second substrates 18 on which the first prism unit 141, the second prism unit 142 and the third prism unit 143 are formed can be directly pressed onto the first intermediate layer 15 to form the structure of the display device 10. To be noted, the above description is illustrative and not restrictive, and the present invention is not limited thereto.

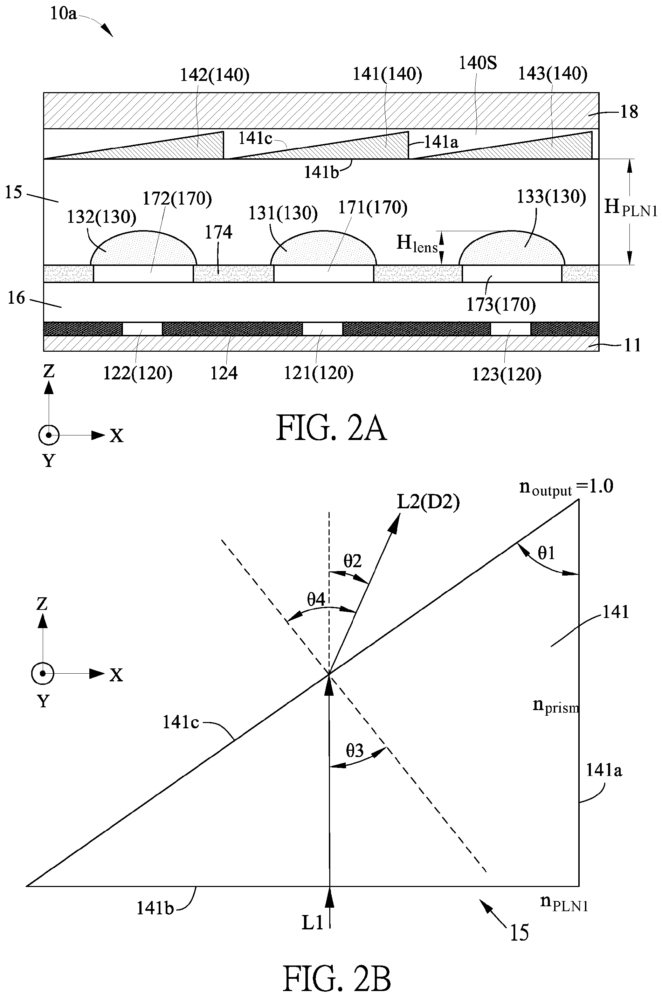

The display device 10a according to a second embodiment of this invention will be described hereinafter with reference to FIGS. 2A and 2B. FIG. 2A is a sectional view showing a part of the display device 10a according to the second embodiment of this invention, and FIG. 2B is a simplified schematic diagram showing that a light beam sequentially passes through the first intermediate layer 15, the prism unit (including, for example, the first prism unit 141, the second prism unit 142 and the third prism unit 143), and the second substrate 18 of the display device 10a of FIG. 2A. To be noted, in this embodiment, the upper side and the lower side of the second substrate 18 are both configured with air, so the second substrate 18 is not shown in the simplified schematic diagram of FIG. 2B based on Snell's law.

The component configurations and connections of the display device 10a of this embodiment as shown in FIGS.

2A and 2B are mostly the same as those of the display device 10 of the previous embodiment. Unlike the previous embodiment, the hypotenuses 141c of the prism units (including, for example, the first prism unit 141, the second prism unit 142 and the third prism unit 143) of the display device 10a are away from the first intermediate layer 15. That is, in each of the prism units, the hypotenuses 141c is farther from the first intermediate layer 15 than the second sides 141b. A space 140S can be formed between the prism unit (e.g. the first prism unit 141, the second prism unit 142 or the third prism unit 143) and the second substrate 18, and the space 140S can be, for example, filled with air.

In this embodiment, the prism units (including, for example, the first prism unit 141, the second prism unit 142, and the third prism unit 143) can be manufactured in any suitable manner. In one embodiment, the light-emitting units (including, for example, the first light-emitting unit 121, the second light-emitting unit 122, and the third light-emitting unit 123), the second interposer 16, the color filter units (including, for example, the first color filter unit 171, a second color filter unit 172, and the third color filter unit 173), the lens units (including, for example, the first lens unit 131, the second lens unit 132, and the third lens unit 133), and the first intermediate layer 15 are formed sequentially on the first substrate 11. Afterwards, the prism units (including, for example, the first prism unit 141, the second prism unit 142, and the third prism unit 143) are formed on the first intermediate layer 15 by using a mold and/or a photolithography process. Then, the second substrate 18 is disposed on the prism units (including, for example, the first prism unit 141, the second prism unit 142, and the third prism unit 143). In other embodiments, the prism units (including, for example, the first prism unit 141, the second prism unit 142, and the third prism unit 143) can be formed on the upper surface of the first intermediate layer 15 by pressing or stamping. In this case, the first intermediate layer 15 and the prism units (including, for example, the first prism unit 141, the second prism unit 142, and the third prism unit 143) may be formed by the same layer. Then, the second substrate 18 is disposed on the prism units (including, for example, the first prism unit 141, the second prism unit 142, and the third prism unit 143), thereby forming the structure of the display device 10a. To be noted, the above description is illustrative and not restrictive, and the present invention is not limited thereto.

In this embodiment, according to FIG. 2B and Snell's law, the following equations can be obtained:

$$\theta_3 = 90 - \theta_1 \qquad \text{equation (16)}$$

$$\theta_4 = \arcsin\left[\ \sin(\theta_3) * n_{prism}/n_{output}\right] \qquad \text{equation (17)}$$

$$\theta_2 = \theta_4 - \theta_3 \qquad \text{equation (18)}$$

Wherein, $\theta_1$ represents the first angle, $\theta_3$ represents the incident angle of the light entering the hypotenuse 141c, $\theta_4$ represents the refraction angle of the light after passing through the hypotenuse 141c, $n_{output}$ represents the refractive index of air (e.g. the refractive index of the environment and, in this embodiment, the refractive index of the air filled between the first prism unit 141 and the second substrate 18), $n_{prism}$ represents the refractive index of the first prism unit 141, and $\theta_2$ represents the second angle.

The second angle $\theta_2$ can be obtained by substituting the equations (16) and (17) into the equation (18) so as to obtain the following equation (19):

$$\theta_2 = \arcsin\left[\sin(90 - \theta_1)*n_{prism}/n_{output}\right] - (90 - \theta_1) \qquad \text{equation (19)}$$

If the environment is air, $n_{output}$ will be equal to 1.0, and the second angle $\theta_2$ can be organized into the following equation (20):

$$\theta_2 = \arcsin\left[\sin(90 - \theta_1)*n_{prism}\right] - (90 - \theta_1) \qquad \text{equation (20)}$$

Moreover, with considering the error range of 10 degrees, the above equation (20) can be rewritten as the following equation (21):

$$\theta_2 = \arcsin\left[\sin(90 - \theta_1)*n_{prism}\right] - (90 - \theta_1) \pm 10 \qquad \text{equation (21)}$$

In this embodiment, the thickness of the first intermediate layer 15 can be defined as being greater than or equal to the thickness of the first lens unit 131 (i.e., $H_{PLN1} \geq H_{lens}$). Wherein, $H_{PLN1}$ represents the thickness (or height) of the first intermediate layer 15, and $H_{lens}$ represents the thickness (or height) of the first lens unit 131.

In brief, on the premise that the output light L2 of the display device 10a can have an expected off-axis angle (i.e., the second angle $\theta_2$), the present invention can use the aforementioned equations (19) to (21) to define the range of the first

angle $\theta_1$. In other words, the internal structures of the display device 10a can be designed and manufactured according to the aforementioned equations (19) to (21). For example, the first angle $\theta_1$ (i.e., the shape and size of the first prism unit 141), the refractive index $n_{prism}$ of the first prism unit 141 (i.e., the material of the first prism unit 141), the refractive index $n_{PLN1}$ of the first intermediate layer 15 (i.e., the material of the first intermediate layer 15), and the likes can be defined according to the aforementioned equations (19) to (21).

The display device 10b according to a third embodiment of this invention will be described hereinafter with reference to FIGS. 3A and 3B. FIG. 3A is a sectional view showing a part of the display device 10b according to the third embodiment of this invention, and FIG. 3B is a simplified schematic diagram showing that a light beam sequentially passes through the first intermediate layer 15, the prism unit (including, for example, the first prism unit 141, the second prism unit 142 and the third prism unit 143), and the second substrate 18 of the display device 10b of FIG. 3A.

The component configurations and connections of the display device 10b of this embodiment as shown in FIGS. 3A and 3B are mostly the same as those of the display device 10 of the previous embodiment. Unlike the previous embodiment, the display device 10b includes a prism portion 340, which includes a prism layer 340A and a plurality of prism units (including, for example, a first prism unit 141, a second prism unit 142, and a third prism unit 143). The prism layer 340A and the plurality of prism units are a continuous structure. For example, the prism layer 340A and the plurality of prism units can be made of the same material and may be integrally formed as one piece. A plurality of prism units 140 are disposed between the first intermediate layer 15 and the prism layer 340A. For convenience of explanation, FIG. 3A shows one prism portion 340. In some embodiments, the display device includes one prism portion 340. In some embodiments, although not shown in the drawings, the display device may include a plurality of prism portions 340, which may include, for example, a first prism portion and a second prism portion. The first prism portion may include a first prism layer and a first part of a plurality of prism units, and the first prism layer and the first part of the prism units are a continuous structure. The second prism portion may include a second prism layer and a second part of the plurality of prism units, and the second prism layer and the second part of the prism units are a continuous structure. The arrangement of the above-mentioned prism portions is not limited in this invention. Although the drawings do not show the arrangement direction of the prism portions, for example, as shown in FIG. 7, the arrangement direction of the prism portions may be in the direction X. For example, the display device includes a plurality of prism portions arranged in the direction X, and one prism portion is disposed corresponding to one row of pixel areas P (or light-emitting units). That is, one prism portion may be disposed overlapping one row of pixel areas P (or light-emitting units). For example, one prism portion can be arranged corresponding to the pixel areas P of the row R3, and another prism portion can be arranged corresponding to the pixel areas P of another row R4. The prism portion corresponding to the row R3 and the other prism portion corresponding to the row R4 can be separated from each other. In another case as shown in FIG. 7, for example, the arrangement direction of the prism portions may be in the direction Y. For example, the display device includes a plurality of prism portions arranged in the direction Y, and one prism portion may correspond to one column of pixel areas P (or light-emitting units). That is, one prism portion may be disposed overlapping one column of pixel areas P (or light-emitting units). For example, one prism portion can be arranged corresponding to the pixel areas P of the column C3, and another prism portion can be arranged corresponding to the pixel areas P of the column C4. The prism portion corresponding to the column C3 and the other prism portion corresponding to the column C4 can be separated from each other. Although not shown in the drawings, in some embodiments, one prism portion can be arranged overlapping the pixel areas P of multiple columns and multiple rows. The row direction is the direction X, and the column direction is the direction Y.

In this embodiment, the prism portion 340 can be manufactured in any suitable manner. In one embodiment, the light-emitting units (including, for example, the first light-emitting unit 121, the second light-emitting unit 122, and the third light-emitting unit 123), the second intermediate layer 16, the color filter units (including, for example, the first color filter unit 171, the second color filter unit 172, and the third color filter unit 173), the lens units (including, for example, the first lens unit 131, the second lens unit 132, and the third lens unit 133), and the first intermediate layer 15 may be formed sequentially on the first substrate 11. In addition, the prism units are directly formed on a surface of a transparent plate (e.g. a glass plate). For example, the prism units (including, for example, the first prism unit 141, the second prism unit 142, and the third prism unit 143) can be defined directly on a surface of a transparent substrate by laser ablation, thereby forming the prism portion 340. Then, one side of the transparent substrate formed with the prism portion 340 is directly bonded to the first intermediate layer 15 to form the structure of the display device 10b. To be noted, the above description is illustrative and not restrictive, and the present invention is not limited thereto.

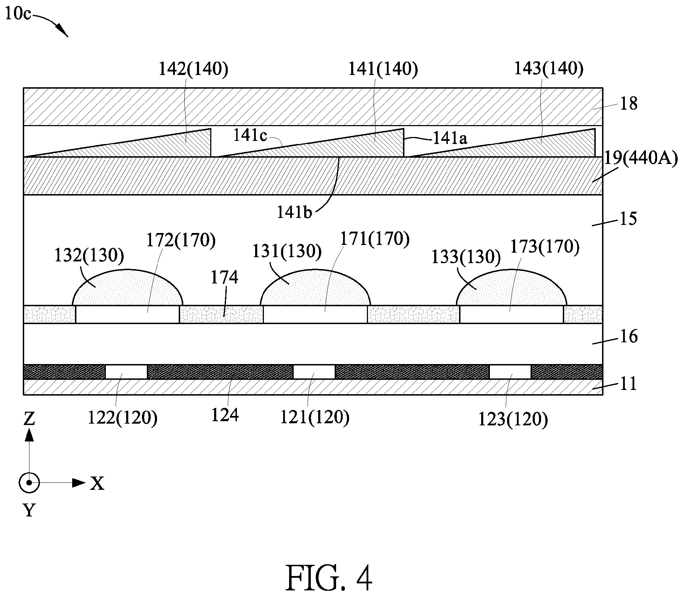

The display device 10c according to a fourth embodiment of this invention will be described hereinafter with reference to FIG. 4. FIG. 4 is a sectional view showing a part of the display device 10c according to the fourth embodiment of this invention.

The component configurations and connections of the display device 10c of this embodiment as shown in FIG. 4 are mostly the same as those of the display device 10a of the previous embodiment as shown in FIG. 2A. Unlike the previous embodiment, the display device 10c further includes a third substrate 19 disposed between the first intermediate layer 15 and the prism units (including, for example, the first prism unit 141, the second prism unit 142, and the third prism unit 143). The material of the third substrate 19 can be any suitable transparent material, which may be, for example but not limited to, the same material as the second substrate 18, so the detailed description thereof will be omitted.

In one embodiment, the third substrate 19 can be, for example, a transparent substrate (e.g. a glass substrate), and the refractive index thereof is, for example but not limited to, between 1.4 and 1.8. In one embodiment, the light-emitting units (including, for example, the first light-emitting unit 121, the second light-emitting unit 122, and the third light-emitting unit 123), the second intermediate layer 16, the color filter units (including, for example, the first color filter unit 171, the second color filter unit 172, and the third color filter unit 173), the lens units (including, for example, the first lens unit 131, the second lens unit 132, and the third lens unit 133), and the first intermediate layer 15 can be sequentially formed on the first substrate 11. In addition, the prism units (including, for example, the first prism unit 141, the second prism unit 142, and the third prism unit 143) are formed on one surface of the third substrate 19 by using, for example, a mold and/or a photolithography process, and then the second substrate 18 is disposed on the prism units (including, for example, the first prism unit 141, the second prism unit 142, and the third prism unit 143). Afterwards, the structure including the third substrate 19, the prism units (including, for example, the first prism unit 141, the second prism unit 142, and the third prism unit 143), and the second substrate 18 is placed on the first intermediate layer 15. In this case, the other surface of the third substrate 19 is directly disposed on the first intermediate layer 15, thereby forming the structure of the display device 10c. To be noted, the above description is illustrative and not restrictive, and the present invention is not limited thereto.

As shown in FIG. 4, in some embodiments, the third substrate 19 can be replaced by a prism layer 440A. Therefore, the prism layer 440A and the plurality of prism units (including, for example, the first prism unit 141, the second prism unit 142, and the third prism unit 143) can be a continuous structure. In one embodiment, for example, the prism layer 440A and the plurality of prism units are made of the same material and may be integrally formed as one piece. In one embodiment, the plurality of prism units 140 are disposed between the prism layer 440A and the second substrate 18. To be noted, the above description is illustrative and not restrictive, and the present invention is not limited thereto.

In brief, the display device 10c of this embodiment can use the above-mentioned equations (19) to (21) to define the range of the first angle $\theta_1$. In other words, the internal structures of the display device 10c can be designed and manufactured according to the aforementioned equations (19) to (21). For example, the first angle $\theta_1$ (i.e., the shape and size of the first prism unit 141), the refractive index $n_{prism}$ of the first prism unit 141 (i.e., the material of the first prism unit 141), the refractive index $n_{PLN1}$ of the first intermediate layer 15 (i.e., the material of the first intermediate layer 15), and the likes can be defined according to the aforementioned equations (19) to (21). In addition, in this embodiment, through the arrangement of the third substrate 19, the display device 10c can be divided into two sub-structural parts that can be manufactured separately. One of the sub-structural parts includes the first substrate 11, the light-emitting units (including, for example, the first light-emitting unit 121, the second light-emitting unit 122, and the third light-emitting unit 123), the second intermediate layer 16, the color filter units (including, for example, the first color filter unit 171, the second color filter unit 172, and the third color filter unit 173), the lens units (including, for example, the first lens unit 131, the second lens unit 132, and the third lens unit 133), and the first intermediate layer 15, while the other sub-structural part includes the third substrate 19, the prism units (including, for example, the first prism unit 141, the second prism unit 142, and the third prism unit 143), and the second substrate 18. Afterwards, the two sub-structural parts are bonded. The above-mentioned manufacturing process can effectively reduce the manufacturing time and manufacturing difficulty.

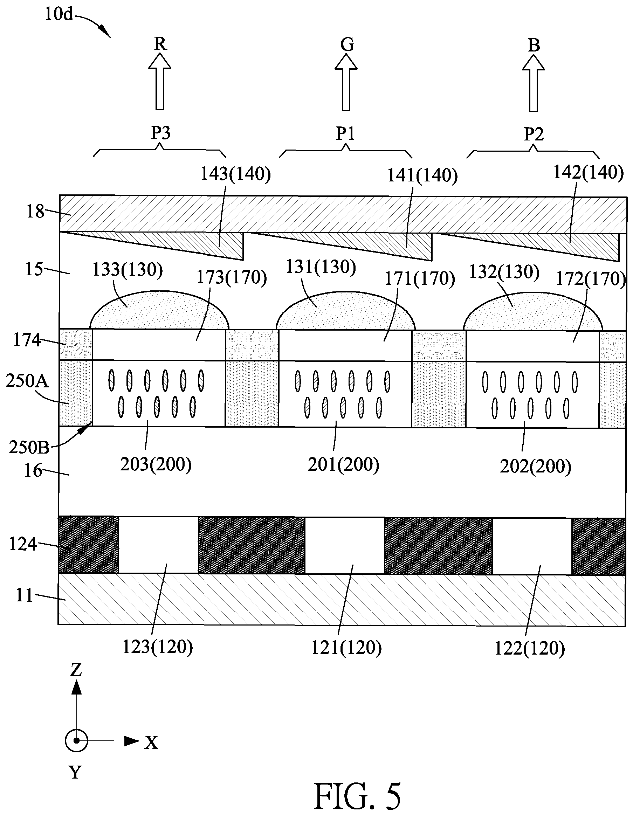

FIG. 5 is a sectional view showing a part of a display device 10d according to an aspect of a fifth embodiment of this invention. The component configurations and connections of the display device 10d of this embodiment as shown in FIG. 5 are mostly the same as those of the display device 10a of the previous embodiment as shown in FIG. 2A. Unlike the previous embodiment, the display device 10d further includes a plurality of optical units 200, which are correspondingly disposed between the light-emitting units 120 (including, for example, the first light-emitting unit 121, the second light-emitting unit 122, and the third light-emitting unit 123) and the color filter units 170 (including, for example, the first color filter unit 171, the second color filter unit 172, and the third color filter unit 173). The optical units 200 may include light conversion materials, light diffusion materials, or other optical materials. In addition, the display device 10d as shown in FIG. 5 includes at least three pixel areas, which are the pixel area P3, the pixel area P1 and the pixel area P2 arranged from left to right. The pixel area P1 is provided between the pixel area P2 and the pixel area P3, and at least includes a first light-emitting unit 121, a first optical unit 201, a first color filter unit 171, a first lens unit 131 and a first prism unit 141. The pixel area P2 is located at the right side of the pixel area P1, and at least includes a second light-emitting unit 122, a second optical unit 202, a second color filter unit 172, a second lens unit 132 and a second prism unit 142. The pixel area P3 is located at the left side of the pixel area P1, and at least includes a third light-emitting unit 123, a third optical unit 203, a third color filter unit 173, a third lens unit 133 and a third prism unit 143. As shown in FIG. 5, in this embodiment, the display device 10d includes three light-emitting units that can emit light of the same color. For example, the first light-emitting unit 121, the second light-emitting unit 122 and the third light-emitting unit 123 all emit blue light, but this invention is not limited thereto. The first optical unit 201 is disposed between the first light-emitting unit 121 and the first color filter unit 171, the second optical unit 202 is disposed between the second light-emitting unit 122 and the second color filter unit 172, and the third optical unit 203 is disposed between the third light-emitting unit 123 and the third color filter unit 173. The first optical unit 201 and the third optical unit 203 can be light conversion units, and the second optical unit 202 can be a light diffusion unit. For example, the third optical unit 203 can convert the blue light emitted by the third light-emitting unit 123 into red light, and the first optical unit 201 can convert the blue light emitted by the first light-emitting unit 121 into green light. Within the positions of the pixel areas P3, P1 and P2, the third color filter unit 173, the first color filter unit 171, and the second color filter unit 172 may be a red color filter, a green color filter, and a blue color filter respectively. Therefore, the positions of the pixel areas P3, P1 and P2 can respectively emit red light, green light, and blue light.

In this embodiment, as shown in FIG. 5, the optical units (including, for example, the first optical unit 201, the second optical unit 202, and the third optical unit 203) may be individually formed by, for example but not limited to, coating processes and photolithography processes. For example, in order to form the first optical unit 201, the second optical unit 202 and the third optical unit 203, a coating process may be used to form a layer of bank material (e.g. an organic photoresist material) on the second intermediate layer 16. Then, the layer of bank material is then patterned by using, for example, a photolithography process to form the bank pattern layer 250A, which may include a plurality of openings 250B. Then, the materials of the first optical unit 201, the second optical unit 202, and the third optical unit 203 are sequentially filled in the plurality of openings 250B of the bank pattern layer 250A through a coating process to form the first optical unit 201, the second optical unit 202 and the third optical unit 203. It should be noted that the above descriptions are examples and are not intended to limit the scope of the present invention, and the present invention is not limited thereto.

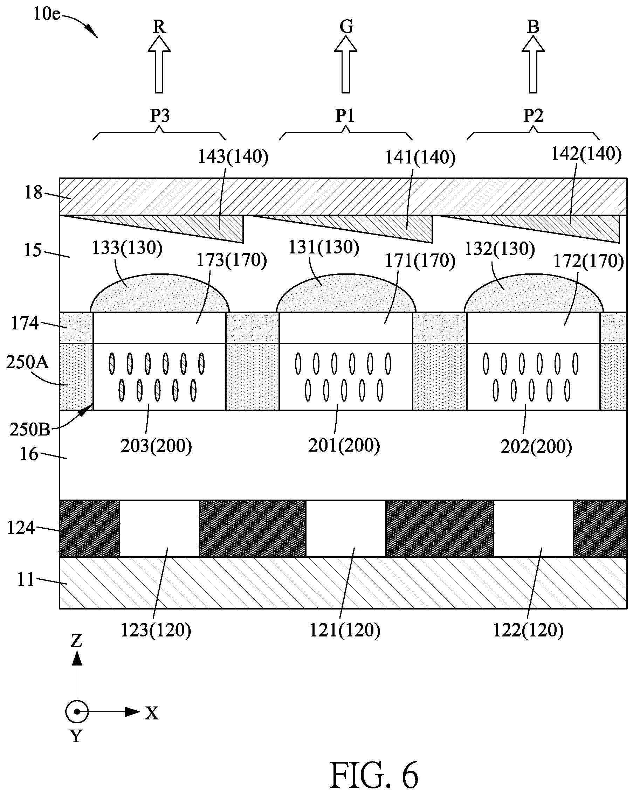

FIG. 6 is a sectional view showing a part of a display device 10e according to another aspect of the fifth embodiment of this invention. The component configurations and connections of the display device 10e of this embodiment as shown in FIG. 6 are mostly the same as those of the display device 10d of the previous embodiment as shown in FIG. 5. Unlike the previous embodiment, the display device 10e includes two blue light-emitting units and one green light-emitting unit. For example, the second light-emitting unit 122 and the third light-emitting unit 123 can be blue light-emitting units, and the first light-emitting unit 121 can be a green light-emitting unit. The third optical unit 203 can be a light conversion unit, and the first optical unit 201 and the second optical unit 202 can be light diffusion units. For example, the third optical unit 203 may convert the blue light emitted by the third light-emitting unit 123 into red light. Within the positions of the pixel areas P3, P1 and P2, the third color filter unit 173, the first color filter unit 171, and the second color filter unit 172 can be a red color filter, a green color filter, and a blue color filter respectively. Therefore, the positions of the pixel areas P3, P1 and P2 can respectively emit red light, green light, and blue light.

In this embodiment, the first substrate 11 may be a substrate including a circuit layer (not shown) that is electrically connected to the first light-emitting unit 121, the second light-emitting unit 122, and the third light-emitting unit 123. The circuit layer includes, for example, a microprocessor, a memory component, and/or other components. The circuit layer may include different passive components and/or active components, such as thin-film resistors, capacitors (e.g. MIMCAP), inductors, diodes, MOSFET, CMOS transistor, BJT, LDMOS transistor, PMOS transistor, TFT, or other types of transistors. In addition, the first substrate 11 may have a bonding surface, such as the upper surface of the first substrate 11. The first substrate 11 can be a driving substrate that drives the first light-emitting unit 121, the second light-emitting unit 122, and the third light-emitting unit 123 to emit light, such as a CMOS substrate, a LCOS substrate, a TFT substrate, or other circuit substrates with working circuit, and this invention is not limited thereto. In some embodiments, any of the above-mentioned display devices is a micro LED display device, suitable for AR or VR applications. In some embodiments, the first substrate 11 may include a plurality of driving elements (not shown). One of the plurality of driving elements can be electrically connected to one of the plurality of light-emitting units 120. Specifically, for example, one of the plurality of driving elements may be electrically connected to the first light-emitting unit 121. The electrodes of the driving element can be electrically connected to the electrodes (not shown) of the first light-emitting unit 121.

Referring to FIG. 1A, any of the first light-emitting unit 121, the second light-emitting unit 122 and the third light-emitting unit 123 includes, for example, an organic light-emitting diode (OLED), a millimeter light-emitting diode (mini LED), a micro light-emitting diode (Micro LED), or a quantum-dot light-emitting diode (QLED), but this invention is not limited thereto. In this embodiment, any one of the first light-emitting unit 121, the second light-emitting unit 122 and the third light-emitting unit 123 can be a micro LED element, such as a red-light micro LED element, a green-light micro LED element, or a blue-light micro LED element. Generally, any one of the first light-emitting unit 121, the second light-emitting unit 122 and the third light-emitting unit 123 includes two semiconductor layers and a light-emitting layer sandwiched between the two semiconductor layers. The semiconductor layer can be an element semiconductor, a compound semiconductor, an alloy semiconductor, a metal oxide, an organic semiconductor, or any combination of the above materials. The element semiconductors include amorphous silicon (amorphous-Si), polycrystalline silicon (poly-Si), germanium, etc. The compound semiconductors include gallium nitride (GaN), silicon carbide, gallium arsenide (GaAs), gallium phosphide, indium phosphide, indium arsenide, and/or indium antimonide, etc. The alloy semiconductors include silicon germanium alloy (SiGe), phosphorus arsenide gallium alloy (GaAsP), arsenic aluminum indium alloy (AlInAs), arsenic aluminum gallium alloy (AlGaAs), arsenic indium gallium alloy (GaInAs), phosphorus indium gallium alloy (GaInP), and/or phosphorus arsenic indium gallium alloy (GaInAsP), etc. The metal oxides include indium gallium zinc oxide (IGZO), indium zinc oxide (IZO), indium gallium zinc tin oxide (IGZTO), etc. The organic semiconductors include polycyclic aromatic compounds. Moreover, the semiconductor layers can be any combination of the above-mentioned materials. It should be noted that the above materials are examples and are not to limit the scope of this invention.

The light-emitting layer may include a homojunction, a heterojunction, a single-quantum well (SQW), a multiple-quantum well (MQW), or other similar structures. In some embodiments, the light-emitting layer may include non-doped n-type $In_xGa_{(1-x)}N$, $Al_xIn_yGa_{(1-x-y)}N$, or any of other suitable materials. In addition, the light-emitting layer may be a multiple-quantum well structure including multiple well layers (e.g. InGaN) and barrier layers (e.g. GaN) arranged in a staggered manner. Furthermore, the formation method of the light-emitting layer may include MOCVD (metal organic chemical vapor deposition), MBE (molecular beam epitaxy), HVPE (hydride vapor phase epitaxy), LPE (liquid phase epitaxy), or any of other appropriate chemical vapor deposition methods.

In this embodiment, the structure of any one of the first lens unit 131, the second lens unit 132 and the third lens unit 133 may, for example, include a flat surface and a convex surface. As shown in FIG. 1A, the structure of any one of the first lens unit 131, the second lens unit 132 and the third lens units 133 may be semi-elliptical. In other embodiments, the structure of any one of the first lens unit 131, the second lens unit 132 and the third lens unit 133 may be a hemispherical shape, a semi-oval shape, or other single elements having a flat surface and a convex surface. In other embodiments, the structure of any one of the first lens unit 131, the second lens unit 132 and the third lens unit 133 may be a polygonal structure or a composite structure. For example, the composite structure may include a hemisphere and a cylinder under the plane surface of the hemisphere. In another case, the composite structure can be composed of a quarter sphere and a quarter ellipsoid. In some embodiments, the material of any one of the first lens unit 131, the second lens unit 132 and the third lens unit 133 may include, for example, inorganic or organic materials. For example, the material of any one of the first lens unit 131, the second lens unit 132 and the third lens unit 133 may be, for example, silicon oxide. In some embodiments, the inorganic material includes, for example, silicon oxide, silicon nitride, silicon carbide, titanium oxide, zirconium oxide, aluminum oxide, phosphosilicate glass (PSG) or borophosphosilicate glass, or any combination of the above-mentioned materials. In some embodiments, the organic material includes, for example, polymers such as SU-8, PermiNex, benzocyclobutene (BCB), or transparent resins including spin-on glass (SOG), or transparent adhesive materials, or any combination of the above materials. This invention is not limited thereto. In some embodiments, any one of the first lens unit 131, the second lens unit 132 and the third lens unit 133 composed of inorganic or organic materials may be manufactured by patterning the corresponding organic or inorganic materials using, for example, a photolithography process. It should be noted that the above description is illustrative and is not restrictive, and the present invention is not limited thereto. In one embodiment, the refractive index $n_{lens}$ of any one of the first lens unit 131, the second lens unit 132 and the third lens unit 133 may be, for example but not limited to, between 1.5 and 2.0 (i.e., $2.0 \geq n_{lens} \geq 1.5$). It should be noted that the above description is illustrative and is not restrictive, and the present invention is not limited thereto.

In this embodiment, any one of the first prism unit 141, the second prism unit 142, and the third prism unit 143 can be made of a transparent material, such as, for example but not limited to, silicon oxide, silicon nitride, silicon carbide, titanium oxide, zirconium oxide, aluminum oxide, or any combination of the above-mentioned materials. In some embodiments, any one of the first prism unit 141, the second prism unit 142, and the third prism unit 143 can be made of, for example, OCA (optical clear adhesive), OCR (optical clear resin), or any of other suitable transparent adhesive materials (e.g. photoresist materials), and the invention is not limited thereto. In some embodiments, the material of any one of the first prism unit 141, the second prism unit 142, and the third prism unit 143 can be made of the same as or different from the material of any one of the first lens unit 131, the second lens unit 132, and the third lens unit 133, and this invention is not limited thereto. In one embodiment, the refractive index $n_{prism}$ of any one of the first prism unit 141, the second prism unit 142, and the third prism unit 143 can be, for example but not limited to, between 1.5 and 2.0 (i.e., $2.0 \geq n_{prism} \geq 1.5$). It should be noted that the above description is illustrative and is not restrictive, and the present invention is not limited thereto.

To be noted, in order to generate the off-axis light after passing through the first prism unit 141, the second prism unit 142 or the third prism unit 143, the first intermediate layer 15 and the prism units (including the first prism unit 141, the second prism unit 142, and the third prism unit 143) may be designed to have different refractive indexes. In one embodiment, the refractive index $n_{PLN1}$ of the first intermediate layer 15 can be, for example but not limited to, between 1.0 and 1.6 (i.e., $1.6 \geq n_{PLN1} \geq 1.0$), and the refractive index $n_{PLN2}$ of the second intermediate layer 16 can also be, for example but not limited to, between 1.0 and 1.6 (i.e., $1.6 \geq n_{PLN2} \geq 1.0$. It should be noted that the above description is only illustrative and is not restrictive, and the present invention is not limited thereto.

As mentioned above, in some embodiments, the first intermediate layer is disposed between the lens unit and the prism unit. The off-axis brightness center of the display device can be achieved based on the arrangement of the lens unit and the prism unit, and the appropriate design of the refractive index and thickness of the first intermediate layer. In some embodiments, by appropriately designing the angle of the hypotenuse of the prism unit (the first angle $\theta_1$), the refractive index $n_{PLN1}$ of the first intermediate layer, and/or the refractive index $n_{prism}$ of the prism unit, it is possible to achieve the display device having the output light focusing at the expected off-axis angle (the second angle $\theta_2$).

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

**Claims**

1. A display device, comprising:

    a first substrate;
    a first light-emitting unit disposed on the first substrate;
    a first lens unit disposed above the first light-emitting unit;
    a first prism unit disposed above the first lens unit;
    a first intermediate layer disposed between the first lens unit and the first prism unit; and
    a second intermediate layer disposed between the first light-emitting unit and the first lens unit.

2. The display device of claim 1, further comprising:
   a first color filter unit disposed between the first light-emitting unit and the first lens unit, wherein the second intermediate layer is disposed between the first light-emitting unit and the first color filter unit.

3. The display device of claim 2, further comprising:
   a first optical unit disposed between the first light-emitting unit and the first color filter unit.

4. The display device of claim 1, wherein in a sectional view of the display device, a first included angle $\theta_0$ is defined by a normal direction of the first substrate and a line from an end of the first lens unit to an end of the corresponding first prism unit, and the first included angle $\theta_0$ matches an equation as follow:

$$\theta_0 \geq \arcsin \left[\sin(\theta_{FWHM})/n_{PLN1}\right]$$

wherein, $\theta_{FWHM}$ is an angle of FWHM (full width at half maximum) of the first optical unit, and $n_{PLN1}$ is a refractive index of the first intermediate layer.

5. The display device of claim 4, further comprising:

    a second light-emitting unit disposed on the first substrate and located next to the first light-emitting unit;
    a second lens unit relatively disposed above the second light-emitting unit; and
    a second prism unit relatively disposed above the second lens unit;
    wherein, the first intermediate layer is further disposed between the second lens unit and the second prism unit, and the second intermediate layer is further disposed between the second light-emitting unit and the second lens unit;
    wherein, in the sectional view of the display device, the first included angle $\theta_0$ matches an equation as follow:

$$\theta_0 \leq \arctan \left[(W_{gap}/2 - W_{lens}/2)/H_{PLN1}\right]$$

wherein, $W_{gap}$ is a distance between the first light-emitting unit and the second light-emitting unit, $W_{lens}$ is a width of the first lens unit, $H_{PLN1}$ is a thickness of the first intermediate layer.

6. The display device of claim 5, further comprising:

    a first color filter unit disposed between the first light-emitting unit and the first lens unit, wherein the second intermediate layer is disposed between the first light-emitting unit and the first color filter unit; and
    a second color filter unit disposed between the second light-emitting unit and the second lens unit, wherein the second intermediate layer is further disposed between the second light-emitting unit and the second color filter unit.

7. The display device of claim 6, further comprising:

    a first optical unit disposed between the first light-emitting unit and the first color filter unit; and
    a second optical unit disposed between the second light-emitting unit and the second color filter unit;
    wherein, the first light-emitting unit and the second light-emitting unit emit same color light, the first optical unit is a color conversion unit, and the second optical unit is a light diffusing unit.

8. The display device of claim 1, wherein the first light-emitting unit generates an emitted light, and the emitted light at least passes through the first lens unit, the first intermediate layer and the first prism unit, and is then outputted from the display device to form an output light into an environment;

wherein, in a sectional view of the display device, the first prism unit has a first side, a second side and a hypotenuse, the first side is parallel to a normal direction of the first substrate, the second side connects the first side to form a right angle, the first side connects the hypotenuse to form a first angle, an included angle of the output light and the normal direction of the first substrate is defined as a second angle, the hypotenuse is disposed adjacent to the first intermediate layer, and the first angle and the second angle match an equation as follow:

$$\theta_2 = \arcsin \left[\sin(90 - \theta_1 - \arcsin[\sin(90 - \theta_1)*n_{PLN1}/n_{prism}])*n_{prism}/n_{output}\right] \pm 10$$

wherein, $n_{PLN1}$ is a refractive index of the first intermediate layer, $n_{prism}$ is a refractive index of the first prism unit, and $n_{output}$ is a refractive index of the environment.

9. The display device of claim 1, wherein the first light-emitting unit generates an emitted light, and the emitted light at least passes through the first lens unit, the first intermediate layer and the first prism unit, and is then outputted from the display device to form an output light into an environment;

wherein, in a sectional view of the display device, the first prism unit has a first side, a second side and a hypotenuse, the first side is parallel to a normal direction of the first substrate, the second side connects the first side to form a right angle, the first side connects the hypotenuse to form a first angle, an included angle of the output light and the normal direction of the first substrate is defined as a second angle, the hypotenuse is disposed away from the first intermediate layer, and the first angle and the second angle match an equation as follow:

$$\theta_2 = \arcsin \left[\sin(90 - \theta_1)*n_{prism}/n_{output}\right] - (90 - \theta_1) \pm 10$$

wherein, $n_{prism}$ is a refractive index of the first prism unit, and $n_{output}$ is a refractive index of the environment.

10. The display device of claim 1, wherein in a sectional view of the display device, the first prism unit has a first side, a second side and a hypotenuse, the first side is parallel to a normal direction of the first substrate, the second side connects the first side to form a right angle, and the hypotenuse is closer to the first intermediate layer than the second side.

11. The display device of claim 10, further comprising;
a second substrate, wherein the first prism unit is disposed between the first intermediate layer and the second substrate.

12. The display device of claim 10, further comprising:
a prism portion, wherein the prism portion comprises a prism layer and a plurality of prism units, the prism layer and the prism units are a continuous structure, and the prism units comprises the first prism unit.

13. The display device of claim 1, wherein in a sectional view of the display device, the first prism unit has a first side, a second side and a hypotenuse, the first side is parallel to a normal direction of the first substrate, the second side connects the first side to form a right angle, and the hypotenuse is farther from the first intermediate layer than the second side.

14. The display device of claim 13, further comprising:
a third substrate disposed between the first intermediate layer and the first prism unit.

15. The display device of claim 13, further comprising:
a prism portion, wherein the prism portion comprises a prism layer and a plurality of prism units, the prism layer and the prism units are a continuous structure, and the prism units comprises the first prism unit.

FIG. 1A

FIG. 1B

FIG. 1C

FIG. 1D

10a

142(140)    141(140)    140S    143(140)

18

141c

141a

141b

15

132(130)    172(170)    174    131(130)    171(170)    133(130)

$H_{PLN1}$

$H_{lens}$

16

173(170)

11

Z

122(120)    124    121(120)    123(120)

X

Y

# FIG. 2A

$n_{output} = 1.0$

L2(D2)

θ2

θ1

θ4

141

Z

$n_{prism}$

X

Y

141c

141a

θ3

141b    15

L1    $n_{PLN1}$

# FIG. 2B

FIG. 3A

FIG. 3B

FIG. 4

10d

R                                         G                                     B

P3                                P1                                P2

143(140)                141(140)                142(140)

18

15

133(130)   173(170)     131(130)   171(170)     132(130)   172(170)

174

250A

250B

203(200)                201(200)                202(200)

16

124

11

123(120)                121(120)                122(120)

Z

X

Y

# FIG. 5

FIG. 6

FIG. 7

Europäisches
Patentamt

European
Patent Office

Office européen
des brevets

# EUROPEAN SEARCH REPORT

**Application Number**

EP 25 17 4389

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/091382 A1 (BRICK PETER [DE] ET AL) 19 March 2020 (2020-03-19) * paragraphs [0063], [0065]; figure 1A * ----- | 1-15 | INV. H10H29/855 |
| X | US 2024/145651 A1 (LIU TUNG-KAI [CN] ET AL) 2 May 2024 (2024-05-02) * paragraphs [0117], [0129] - [0134]; figures 5,9 * ----- | 1,13,14 | |

**TECHNICAL FIELDS SEARCHED (IPC)**

H10H

The present search report has been drawn up for all claims

| Place of search | Date of completion of the search | Examiner |
|---|---|---|
| The Hague | 6 October 2025 | Pérennès, Frédéric |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons
.........................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 17 4389

This annex lists the patent family members relating to the patent documents cited in  the above-mentioned European search report.
The members are as contained in the European Patent Office EDP file on
The European Patent Office is in no way liable for these particulars which are merely given for the purpose of information.

06-10-2025

| Patent document cited in search report | Publication date | Patent family member(s) | Publication date |
|---|---|---|---|
| US 2020091382 A1 | 19-03-2020 | DE 102017106033 A1 | 27-09-2018 |
| | | US 2020091382 A1 | 19-03-2020 |
| | | WO 2018172255 A1 | 27-09-2018 |
| US 2024145651 A1 | 02-05-2024 | CN 116259699 A | 13-06-2023 |
| | | DE 112021007622 T5 | 11-04-2024 |
| | | JP 7743545 B2 | 24-09-2025 |
| | | JP 2024529847 A | 14-08-2024 |
| | | US 2024145651 A1 | 02-05-2024 |
| | | WO 2023103008 A1 | 15-06-2023 |

EPO FORM P0459

For more details about this annex : see Official Journal of the European Patent Office, No. 12/82